# EUROPEAN PATENT APPLICATION

(11) **EP 4 486 091 A1**
(43) Date of publication of application: **01.01.2025**
(21) Application number: 22968252.1
(22) Date of filing: 16.12.2022
(51) Int. Cl.: H10K 59/122

(54) **DISPLAY SUBSTRATE AND DISPLAY APPARATUS**

(71) Applicant: Boe Technology Group Co., Ltd., Beijing 100015 (CN); Yunnan Invensight Optoelectronics Technology Co., Ltd., Kunming, Yunnan 650211 (CN)
(72) Inventor: WEI, Junbo, Beijing 100176 (CN); YANG, Shengji, Beijing 100176 (CN); LU, Pengcheng, Beijing 100176 (CN); HUANG, Kuanta, Beijing 100176 (CN); TIAN, Yuanlan, Beijing 100176 (CN)
(74) Representative: Durán-Corretjer, S.L.P.
(86) International application number: PCT/CN2022/139674
(87) International publication number: WO 2024/124548

(57) **Abstract**

Provided is a display substrate. The display substrate comprises a pixel definition layer (304), which is arranged on a base (101), wherein the pixel definition layer (304) is provided with a pixel opening, the pixel opening exposes at least part of the surface of a first electrode (301), and at least part of a second electrode (303) covers the pixel opening; and the pixel definition layer (304) comprises a first side face which is close to one side of the first electrode (301), wherein the first side face comprises n first steps (1) which are successively arranged in the light emission direction of a light-emitting functional layer (302), the first steps (1) each comprise a first step side face (11), a slope angle ai of the first step side face (11) of an ith first step (1) is greater than a slope angle aj of the first step side face (11) of a jth first step (1), and the ith first step (1) is located on the side of the jth first step (1) that is close to the base (101), all of i, j and n being natural numbers, n being greater than 1, and 0<i<j≤n. Further provided is a display apparatus.

## Description

### Technical Field

The present disclosure relates to, but is not limited to, the field of display technologies, and particularly relates to a display substrate and a display apparatus.

### Background

A Micro Organic Light Emitting Diode (Micro OLED for short) display has gradually become a hot spot of display technologies. Micro OLED displays are mainly used in and fields such as near-eye display, virtual reality and augmented reality. A Micro OLED may be used in a near-eye display device, such as an AR/VR head-mounted display apparatus.

The Micro OLED is a new OLED display apparatus using a silicon substrate as a base substrate. The Micro OLED has characteristics of small size and high resolution, and the Micro OLED is made of mature Complementary Metal Oxide Semiconductor (CMOS for short) technology, which realizes active addressing of pixels and realizes lightweight.

### Summary

The following is a summary of subject matter described herein in detail. This summary is not intended to limit the protection scope of the claims.

In a first aspect, the present disclosure provides a display substrate, including:
a base substrate;
a light emitting element disposed on the base substrate, the light emitting element including a first electrode, a light emitting functional layer, and a second electrode that are sequentially stacked along a direction away from the base substrate;
a pixel definition layer disposed on the base substrate, the pixel definition layer is provided with a pixel opening, the pixel opening exposes at least a portion of a surface of the first electrode, and at least a portion of the second electrode covers the pixel opening;
wherein the pixel definition layer includes a first side surface on a side close to the first electrode, the first side surface includes n stages of first steps that are sequentially arranged along a light emitting direction of the light emitting functional layer, each first step includes a first step side surface, a slope angle of a first step side surface of a first step of an i-th stage is greater than a slope angle of a first step side surface of a first step of a j-th stage, and the first step of the i-th stage is located on a side of the first step of the j-th stage close to the base substrate;
where i, j and n are all natural numbers, n is greater than 1, and 0 < i < j ≤ n.

In some examples, the first side surface includes 3 stages of first steps that are sequentially arranged along the light emitting direction of the light emitting functional layer, a slope angle of a first step side surface of a first step of a first stage is greater than a slope angle of a first step side surface of a first step of a second stage, and the slope angle of the first step side surface of the first step of the second stage is greater than a slope angle of a first step side surface of a first step of a third stage.

In some examples, the slope angle of the first step side surface of the first step of the first stage is 65 degrees to 75 degrees; the slope angle of the first side surface of the first step of the second stage is 50 degrees to 60 degrees; and the slope angle of the first step side surface of the first step of the third stage is 40 degrees to 45 degrees.

In some examples, a thickness of the first step of the i-th stage is greater than a thickness of the first step of the j-th stage.

In some examples, a length of the first step of the i-th stage is greater than a length of the first step of the j-th stage.

In some examples, the pixel definition layer further includes a second side surface on a side away from the first electrode, the second side surface includes one second step, the second step includes a second step side surface, and a slope angle of the second step side surface of the second step is greater than the slope angle of the first step side surface of the first step of the i-th stage.

In some examples, the slope angle of the second step side surface of the second step is 80 degrees to 90 degrees.

In some examples, the pixel definition layer further includes a second side surface on a side away from the first electrode, the second side surface includes m stages of second steps that are sequentially arranged along the light emitting direction of the light emitting functional layer, each second step includes a second step side surface, a slope angle of a second step side surface of a second step of a z-th stage is greater than a slope angle of a second step side surface of a second step of a k-th stage, and the second step of the z-th stage is located on a side of the second step of the k-th stage close to the base substrate.

In some examples, the m stages of the second steps are disposed in mirror symmetry with the n stages of the first steps with respect to an axis which is a center line of the pixel definition layer perpendicular to a direction of the base substrate.

In some examples, a quantity of the m stages of the second steps is less than a quantity of the n stages of the first steps.

In some examples, an orthographic projection of at least a portion of the second step side surface of the second step on the base substrate is not overlapped with an orthographic projection of the first electrode on the base substrate; and a distance between an edge of the second step side surface away from the first side surface and an edge of the first electrode away from the first side surface is greater than 150Å.

In some examples, the second electrode includes a first portion covering the first side surface and a second portion covering the second step, the first portion is connected with the second portion, a surface of the first portion includes at least one first curved surface, a surface of the second portion includes at least one second curved surface, a curvature change of the at least one first curved surface is less than a curvature change of the at least one second curved surface.

In some examples, a slope angle of the second portion is 35 degrees to 45 degrees.

In some examples, the second side surface further includes one third step, the third step is located between the second step and the base substrate, the third step includes a third step side surface, and a slope angle of the third step side surface of the third step is less than the slope angle of the second step side surface of the second step.

In some examples, a length of the third step is greater than a sum of a total length of the n stages of first steps and a length of the second step.

In some examples, the second side surface includes r stages of third steps that are sequentially arranged along the light emitting direction of the light emitting functional layer, the r stages of third steps are located between the second step and the base substrate, each third step includes a third step side surface, a slope angle of a third step side surface of a third step of a o-th stage is less than a slope angle of a third step side surface of a third step of a p-th stage, and the third step of the o-th stage is located on a side of the third step of the p-th stage close to the base substrate.

In some examples, a surface of the second electrode is uneven, and a distance between a highest point of the surface of the second electrode and a lowest point of the surface of the second electrode is less than 800Å.

In some examples, a length of the first step side surface of the first step is 10% to 15% of a thickness of the first electrode.

In some examples, the light emitting functional layer includes a first film layer portion located on a side close to the base substrate and a second film layer portion located on a side away from the base substrate, and the first film layer portion forms at least one protrusion part at the n stages of the first steps.

In another aspect, the present disclosure further provides a display apparatus, including the aforementioned display substrate.

Other aspects may become clear after the accompanying drawings and the detailed description are read and understood.

### Brief Description of Drawings

Accompanying drawings are used for providing an understanding for technical solutions of the present application and constitute a part of the specification, are used for explaining the technical solutions of the present application together with embodiments of the present application, and do not constitute a limitation on the technical solutions of the present application.
FIG. 1 is a schematic diagram of a structure of a display apparatus.
FIG. 2 is a first schematic diagram of a structure of a display substrate according to an embodiment of the present application.
FIG. 3 is a schematic diagram of a planar structure of a display area in a display substrate according to an embodiment of the present application.
FIG. 4 is a schematic cross-sectional view of a structure of a display area in a display substrate according to an embodiment of the present application.
FIG. 5 is a first schematic diagram of a display substrate according to an embodiment of the present disclosure.
FIG. 6 is a second schematic diagram of a display substrate according to an embodiment of the present disclosure.
FIG. 7 is a schematic cross-sectional view of a structure of a light emitting structure layer in a display substrate according to an embodiment of the present application.
FIG. 8 is a partial enlarged view of a display substrate according to an embodiment of the present application.
FIG. 9 is a first enlarged view of a pixel definition layer in a display substrate according to an embodiment of the present application.
FIG. 10 is a second enlarged view of a pixel definition layer in a display substrate according to an embodiment of the present application.
FIG. 11 is a third enlarged view of a pixel definition layer in a display substrate according to an embodiment of the present application.
FIG. 12 is a fourth enlarged view of a pixel definition layer in a display substrate according to an embodiment of the present application.
FIG. 13 is an enlarged view of a second electrode in a display substrate according to an embodiment of the present application.
FIG. 14 is a second schematic diagram of a structure of a display substrate according to an embodiment of the present application.

### Detailed Description

To make objectives, technical solutions, and advantages of the present disclosure clearer, the embodiments of the present disclosure will be described in detail with reference to the accompanying drawings. It is to be noted that implementations may be practiced in multiple different forms. Those of ordinary skills in the art may easily understand such a fact that implementations and contents may be transformed into various forms without departing from the purpose and scope of the present disclosure. Therefore, the present disclosure should not be explained as being limited to contents described in following implementations only. The embodiments in the present disclosure and features in the embodiments may be combined randomly with each other if there is no conflict.

In the drawings, a size of a constituent element, a thickness of a layer, or a region is exaggerated sometimes for clarity. Therefore, one implementation of the present disclosure is not necessarily limited to the size, and shapes and sizes of various components in the drawings do not reflect actual scales. In addition, the drawings schematically illustrate ideal examples, and one implementation of the present disclosure is not limited to shapes, numerical values, or the like shown in the drawings.

Ordinal numerals such as "first", "second", and "third" in the specification are set to avoid confusion between constituent elements, but not to set a limit in quantity.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred device or element must have a particular orientation and be constructed and operated in the particular orientation. Therefore, they cannot be understood as limitations on the present disclosure. The positional relationships between the constituent elements may be changed as appropriate according to directions for describing the various constituent elements. Therefore, appropriate replacements may be made according to situations without being limited to the wordings described in the specification.

In the specification, unless otherwise specified and defined explicitly, terms "mount", "mutually connect", and "connect" should be understood in a broad sense. For example, a connection may be a fixed connection, a detachable connection, or an integrated connection; it may be a mechanical connection or an electrical connection; it may be a direct mutual connection, or an indirect connection through a middleware, or internal communication between two elements. Those of ordinary skills in the art may understand specific meanings of these terms in the present disclosure according to specific situations.

In the specification, a transistor refers to an element which at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that, in the specification, the channel region refers to a region through which the current mainly flows.

In the specification, a first electrode may be a drain electrode, and a second electrode may be a source electrode. Or, the first electrode may be a source electrode, and the second electrode may be a drain electrode. In a case that transistors with opposite polarities are used, in a case that a direction of a current is changed during operation of a circuit, or the like, functions of the "source electrode" and the "drain electrode" are sometimes interchangeable. Therefore, the "source electrode" and the "drain electrode" are interchangeable in the specification.

In the specification, an "electrical connection" includes a case that constituent elements are connected together through an element having certain electrical function. The "element with the certain electrical effect" is not particularly limited as long as electrical signals may be sent and received between the connected constituent elements. Examples of the "element with the certain electrical effect" not only include electrodes and wirings, but also include switch elements such as transistors, resistors, inductors, capacitors, other elements with various functions, etc.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

In the present disclosure, "about" refers to that a boundary is defined not so strictly and numerical values within process and measurement error ranges are allowed.

A Micro OLED display substrate may be used in a near-eye display device. A fixed position of a display substrate is very important for users, which determines the user experience. On the one hand, the existing display substrate is used in an AR/VR device, and a conventional CGL partition mode of stacked devices mostly adopts a way of "digging grooves down" or "bulging up" to create segment difference in space between pixels, and increases a CGL resistance to a certain extent by extending a CGL path, thus reducing a leakage between pixels. On the other hand, in a manufacturing process of an OLED on silicon display device, it is impossible to fundamentally cut off a leakage path caused by CGL from a perspective of cut-off effect evaluation, and this kind of scheme is affected by the segment difference, the segment difference is accompanied by drastic changes in morphology of a second electrode, which affects uniformity of electric field distribution between a cathode and a first electrode, thus adversely affecting a longitudinal leakage of a display substrate. There are also many constraints on the process implementation scheme of this kind of structure. Affected by the process stability and uniformity, the stability of this kind of partition structure greatly affects the product.

Solutions of the embodiments will be described below through some examples.

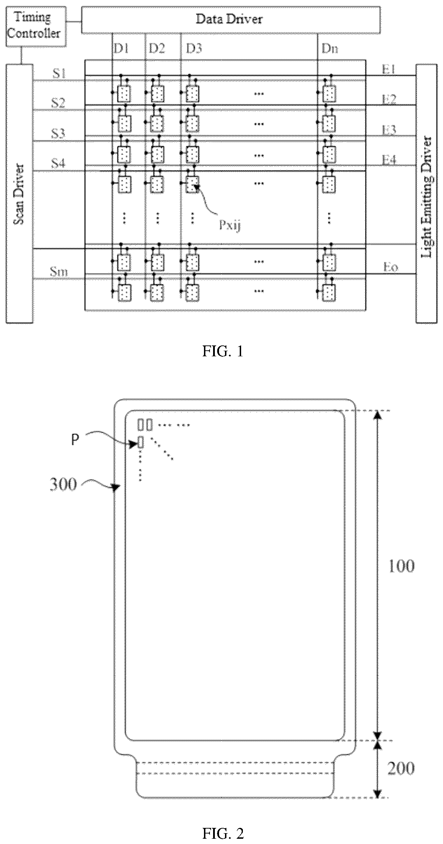

FIG. 1 is a schematic diagram of a structure of a display apparatus. As shown in FIG. 1, the display apparatus may include a timing controller, a data signal driver, a scan signal driver and a pixel array. The pixel array may include multiple scan signal lines (S1 to Sm), multiple data signal lines (D1 to Dn) and multiple sub-pixels Pxij. In an exemplary implementation, the timing controller may provide the data signal driver with a grayscale value and a control signal which are suitable for a specification of the data signal driver, and provide the scan signal driver with a clock signal, a scan start signal, and the like which are suitable for a specification of the scan signal driver. The data signal driver may generate data voltages to be provided to data signal lines D1, D2, D3, ..., and Dn using the grayscale value and the control signal received from the timing controller. For example, the data signal driver may sample the grayscale values using the clock signal and apply the data voltages corresponding to the grayscale values to the data signal lines D1 to Dn by taking a row of sub-pixels as a unit, wherein n may be a natural number. The scan signal driver may generate scan signals to be provided to scan signal lines S1, S2, S3, ..., and Sm by receiving a clock signal, a scan start signal, and the like from the timing controller. For example, the scan signal driver may sequentially provide scan signals with on-level pulses to the scan signal lines S1 to Sm. For example, the scan signal driver may be constructed in the form of a shift register, and generate the scan signals by sequentially transmitting the scan starting signals provided in the form of on-level pulses to a next-stage circuit under the control of the clock signal, wherein m may be a natural number. A sub-pixel array may include multiple sub-pixels PXij. Each sub-pixel PXij may be connected to a corresponding data signal line and a corresponding scan signal line, wherein i and j may be natural numbers. The sub-pixel Pxij may refer to a sub-pixel in which a transistor is connected to both the i-th scan signal line and the j-th data signal line.

FIG. 2 is a first schematic diagram of a structure of a display substrate according to an embodiment of the present application. In an exemplary implementation, as shown in FIG. 2, the display substrate may include a display area 100, a bonding area 200 located on a side of the display area 100, and a bezel area 300 located at other sides of the display area 100.

In an exemplary implementation, as shown in FIG. 2, the display area 100 may be a planar area including multiple sub-pixels Pxij that form a pixel array. The multiple sub-pixels Pxij are configured to display a dynamic picture or a static image, and the display area 100 may be referred to as an Active Area (AA for short). In some examples, the display substrate may be a flexible substrate, and accordingly the display substrate can be deformed, for example, can be crimped, bent, folded, or curled.

In some examples, the bonding area 200 may include a fan-out region, a bending region, a drive chip region, and a bonding pin region that are arranged sequentially along a direction away from the display area 100. The fan-out region is connected with the display area 100 and at least includes data fan-out lines. Multiple data fan-out lines are configured to be connected with the data signal lines of the display area 100 in a fan-out routing manner. The bending region is connected with the fan-out region and may include a composite insulation layer provided with a groove, and is configured to bend the driver chip region and the bonding pin region to the back of the display area 100. An integrated circuit (IC for short) may be disposed in the drive chip region, and the integrated circuit may be configured to be connected with the multiple data fan-out lines. The bonding pin region may include a bonding pad, and the bonding pad may be configured to be bound and connected with an external flexible printed circuit (FPC).

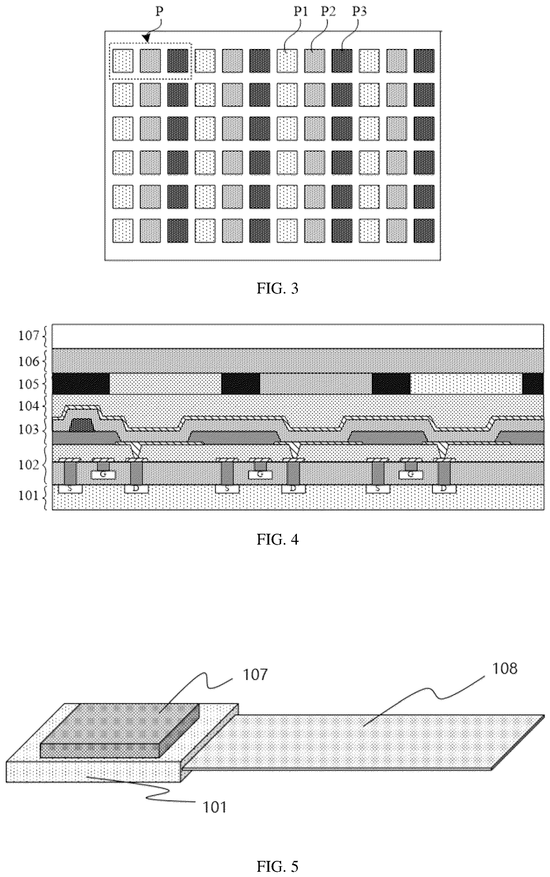

FIG. 3 is a schematic diagram of a planar structure of a display area in a display substrate according to an embodiment of the present application. As shown in FIG. 3, the display area may include multiple pixel units P arranged in a matrix, at least one of the multiple pixel units P includes a first sub-pixel P1 emitting light of a first color, a second sub-pixel P2 emitting light of a second color, and a third sub-pixel P3 emitting light of a third color. The first sub-pixel P1, the second sub-pixel P2, and the third sub-pixel P3 each includes a pixel drive circuit and a light emitting device. The pixel drive circuit in each sub-pixel is respectively connected with a scan signal line and a data signal line, and the pixel drive circuit is configured to receive a data voltage transmitted by the data signal line and output a corresponding current to the light emitting device for display, under control of the scan signal line. The light emitting device for display in the sub-pixel is connected with the pixel drive circuit of the sub-pixel where the light emitting device is located, and the light emitting device for display is configured to emit light with corresponding brightness in response to the current output by the pixel drive circuit of the sub-pixel where the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation, a sub-pixel may be in a shape of any one or more of a triangle, a square, a rectangle, a rhombus, a trapezoid, a parallelogram, a pentagon, a hexagon, and another polygon, and may be arranged side by side horizontally, side by side vertically, in a shape of X, in a shape of a cross, in a shape of a Chinese character " 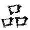 ", in a shape of a square, in a shape of a diamond, or in a shape of a delta, etc., and the present disclosure is not limited thereto.

In an exemplary implementation, the pixel unit may include four sub-pixels, which is not limited in the present disclosure.

FIG. 4 is a schematic cross-sectional view of a structure of a display area in a display substrate according to an embodiment of the present application, which illustrates a structure in which full color is achieved in a manner of white light + color filter. As shown in FIG.4, the display substrate may include a base substrate 101, a drive circuit layer 102 disposed on the base substrate 101, a light emitting structure layer 103 disposed on a side of the drive circuit layer 102 away from the base substrate 101, a first encapsulation layer 104 disposed on a side of the light emitting structure layer 103 away from the base substrate 101, a color filter structure layer 105 disposed on a side of the first encapsulation layer 104 away from the base substrate 101, a second encapsulation layer 106 disposed on a side of the color film structure layer 105 away from the base substrate 101, and a cover plate layer 107 disposed on a side of the second encapsulation layer 106 away from the base substrate 101. In some possible implementations, an OLED on silicon display apparatus may include other film layers such as a touch structure layer. The present disclosure is not limited herein.

In an exemplary implementation, the base substrate 101 may be a bulk base substrate on silicon or a silicon-on-insulator (SOI) base substrate. The drive circuit layer 102 may be manufactured on the base substrate 101 through a silicon semiconductor process (e.g., a CMOS process). The drive circuit layer 102 may include multiple circuit units, a circuit unit may at least include a pixel drive circuit connected with a scan signal line and a data signal line, respectively. The pixel drive circuit may include multiple transistors and a storage capacitor. One transistor is shown only in FIG. 4 as an example. A transistor may include a control electrode G, a first electrode S, and a second electrode D. The control electrode G, the first electrode S, and the second electrode D may be respectively connected with corresponding connection electrodes through vias filled with wolfram metal (i.e., wolfram vias, W-vias), and may be connected with other electrical structures (such as wires) through the connection electrodes.

In some examples, the pixel drive circuit may be in a structure of 3T1C, 4T1C, 5T1C, 5T2C, 6T1C, 7T1C, or 8T1C. In the above circuit structures, T refers to a thin film transistor, C refers to a capacitor, a number before T represents a quantity of thin film transistors in the circuit, and a number before C represents a quantity of capacitors in the circuit. In some examples, the multiple transistors in the pixel drive circuit may be P-type transistors or may be N-type transistors. Use of a same type of transistors in a pixel drive circuit may simplify a process flow, reduce process difficulties of a display substrate, and improve a yield of products. In some other examples, the multiple transistors in the pixel drive circuit may include P-type transistors and N-type transistors.

In an exemplary implementation, the light emitting structure layer 103 may include multiple light emitting devices, the light emitting devices may at least include a first electrode, a light emitting functional layer, and a second electrode, which may be stacked sequentially along a direction away from the base substrate. The first electrode may be connected with the second electrode D of the transistor through a connection electrode, the light emitting functional layer is connected with the first electrode, the second electrode is connected with the light emitting functional layer, and the second electrode is connected with the second electrode voltage line, and the light emitting functional layer emits light under driving by the first electrode and the second electrode. In an exemplary implementation, the light emitting functional layer may include a Light Emitting Layer (EML for short), and any one or more of the followings: a Hole Injection Layer (HIL for short), a Hole Transport Layer (HTL for short), an Electron Block Layer (EBL for short), a Hole Block Layer (HBL for short), an Electron Transport Layer (ETL for short), an Electron Injection Layer (EIL for short), and a Charge Generation Layer (CGL for short). In an exemplary implementation, for a light emitting device emitting white light, the light emitting functional layers of all sub-pixels may be connected together to form a common layer.

In an exemplary implementation, the light emitting structure layer 103 may further include a pixel definition layer, the pixel definition layer is provided with a pixel opening. A portion of a surface of the first electrode is exposed from the pixel opening, and a light emitting functional layer is provided in the pixel opening and connected with the first electrode. At least a portion of the second electrode covers the pixel opening. Among them, the first electrode may be an anode and the second electrode may be a cathode.

In an exemplary implementation, the first encapsulation layer 104 and the second encapsulation layer 106 may be in a Thin Film Encapsulation (TFE for short) mode, which ensures that external moisture cannot enter the light emitting structure layer. Both the encapsulation layer 104 and the second encapsulation layer 106 may be made of an organic material or an inorganic material, and the inorganic material may be silicon oxide or silicon nitride, etc.

In an exemplary implementation, the color filter structure layer 105 may include a black matrix (BM for short) and color filters (CFs for short). A position of a color filter may correspond to a position of a light emitting device, and the black matrix may be located between adjacent color filters. The color filter is configured to filter the white light emitted by the light emitting device into red (R) light, green (G) light, and blue (B) light, forming red, green, and blue sub pixels.

In an exemplary implementation, the cover plate layer 107 may be made of glass or having flexible properties, such as plastic cement colorless polyimide.

FIG. 5 is a first schematic diagram of a display substrate according to an embodiment of the present disclosure. In some examples, as shown in FIG. 5, the display substrate may further include a Flexible Printed Circuit (FPC for short) 108, and the flexible printed circuit 108 may be bound to a bonding pin region of the bonding area 200 such that multiple signal lead lines (e.g., drive control lines, power lines, etc.) on the display substrate are connected with an external control device through multiple bonding pins and the flexible circuit board 108.

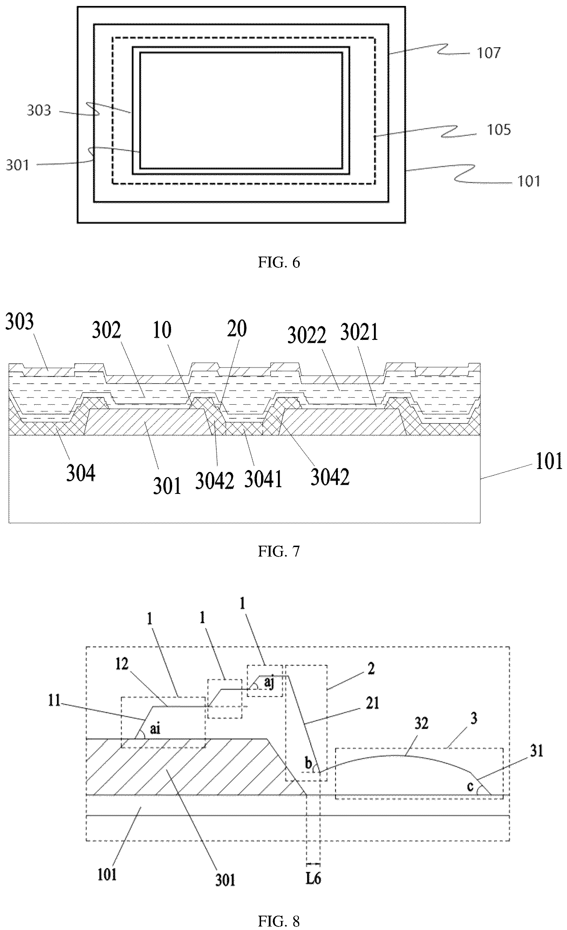

FIG. 6 is a second schematic diagram of a display substrate according to an embodiment of the present disclosure. In some examples, as shown in FIG. 6, an orthographic projection of the cover plate 107 on the base substrate 101 is located in the base substrate 101, and an area of the orthographic projection of the cover plate 107 on the base substrate 101 is less than an area of the base substrate 101. For example, both the cover plate 107 and the base substrate 101 may be rectangular, and edges of the cover plate 107 are all retracted relative to edges of the base substrate 101. The cover plate 107 covers the first electrode 301, the light emitting functional layer 303 and the color filter structure layer 105, and an edge of the cover plate 107 extends beyond an edge of the first electrode 301, the light emitting functional layer 303 and the color filter structure layer 105, so that the edge of the cover plate 107 can be positioned and fixed.

In some examples, as shown in FIG. 6, an orthographic projection of the color filter structure layer 105 on the base substrate 101 is located in the orthographic projection of the cover plate 107 on the base substrate 101, and an area of the orthographic projection of the color filter structure layer 105 on the base substrate 101 is less than an area of an orthographic projection of the cover plate 107 on the base substrate 101. For example, both the color filter structure layer 105 and the cover plate 107 may be rectangular, and edges of the color filter structure layer 105 are all retracted relative to the edges of the cover plate 107. The color filter structure layer 105 covers the first electrode 301 and the light emitting functional layer 303.

In some examples, as shown in FIG. 6, an orthographic projection of the light emitting functional layer 303 on the base substrate 101 is located in the orthographic projection of the color filter structure layer 105 on the base substrate 101, and an area of the orthographic projection of the light emitting functional layer 303 on the base substrate 101 is less than an area of the orthographic projection of the color filter structure layer 105 on the base substrate. For example, both the light emitting functional layer 303 and the color filter structure layer 105 may be rectangular, and edges of the light emitting functional layer 303 are all retracted relative to the edges of the color filter structure layer 105. The light emitting functional layer 303 covers the first electrode 301 and the edges of the light emitting functional layer 303 extends beyond edges of the first electrode 301.

In some examples, as shown in FIG. 6, an orthographic projection of the first electrode 301 on the base substrate 101 is located in the orthographic projection of the light emitting functional layer 303 on the base substrate, and an area of the orthographic projection of the first electrode 301 on the base substrate 101 is less than an area of the orthographic projection of the light emitting functional layer 303 on the base substrate 101. For example, both the first electrode 301 and the light emitting functional layer 303 may be rectangular, and the edges of the first electrode 301 are all retracted relative to the edges of the light emitting functional layer 303.

FIG. 7 is a schematic cross-sectional view of a structure of a light emitting structure layer in a display substrate according to an embodiment of the present application. FIG. 7 illustrates structures of two light emitting devices. In an exemplary implementation, the display substrate of the embodiment of the present disclosure may include more than two light emitting devices. In addition, FIG. 7 shows that the two light emitting devices are adjacent to each other, but the embodiments of the present disclosure are not limited thereto. That is, other components such as wires may be between the two light emitting devices. In FIG. 7, cross-sections of the two light emitting devices may not be cross-sections in a same direction as the display substrate.

In some examples, as shown in FIG. 7, a light emitting device may include at least a first electrode 301, a light emitting functional layer 302, and a second electrode 303 that are sequentially stacked along the direction away from the base substrate 101. The light emitting functional layer 302 is connected with the first electrode 301, the second electrode 303 is connected with the light emitting functional layer 302, and the light emitting functional layer 302 emits light under driving by the first electrode 301 and the second electrode 302. A portion of the pixel definition layer 304 is disposed on the first electrode 301, the pixel definition layer 304 is provided with a pixel opening, the pixel opening may expose a portion of a surface of the first electrode 301, and a portion of the light emitting functional layer 302 is provided in the pixel opening and connected with the first electrode 301. An orthographic projection of the second electrode 203 on the base substrate is overlapped with an orthographic projection of the pixel opening on the base substrate and at least a portion of the second electrode 203 covers the pixel opening.

In some examples, as shown in FIG. 7, a groove body is formed between first electrodes 301 in adjacent light emitting devices. An intermediate portion 3041 of the pixel definition layer 304 is located in the groove body between adjacent first electrodes 301, an edge portion 3042 of the pixel definition layer 304 covers a side surface and a partial surface of a first electrodes 301, and the edge portion 3042 of the pixel definition layer 304 and the intermediate portion 3041 of the pixel definition layer 304 form a step shape. A thickness of the intermediate portion 3041 of the pixel definition layer 304 is less than a thickness of the first electrode 301.

In some examples, as shown in FIG. 7, the edge portion 3042 of the pixel definition layer 304 includes a first side surface 10 close to the first electrode 301 and the first side surface 10 is a sidewall of the pixel opening in the pixel definition layer 304. An included angle formed between the first side surface 10 and a surface of the first electrode 301 away from the base substrate 101 may be obtuse so that a light emitting area of a sub-pixel can be increased. In some embodiments, the first side surface may form a right angle with the surface of the first electrode 301 away from the base substrate 101.

FIG. 8 is a partial enlarged view of a display substrate according to an embodiment of the present application. In some examples, as shown in FIG. 7 and FIG. 8, the first side surface 10 includes n stages of first steps 1 that are sequentially arranged along a light emitting direction of the light emitting functional layer 302, each first step 1 includes a first step side surface 11 and a first step top surface 12. An extension direction of the first step side surface 11 is different from an extension direction of the first step top surface 12, and an obtuse angle is formed between the extension direction of the first step side surface 11 and a surface of the first electrode 301 away from the base substrate 101, and an extension direction of the first step top surface 12 is substantially parallel to the surface of the first electrode 301 away from the base substrate 101. A slope angle ai of a first step side surface 11 of the first step 1 of the i-th stage of is larger than a slope angle aj of a first step side surface 11 of the j-th stage of a first step 1, the first step 1 of the i-th stage is located on a side of the first step 1 of the j-th stage close to the base substrate, and an orthographic projection of the first step 1 of the i-th stage on the base substrate 101 is not overlapped with an orthographic projection of the first step 1 of the j-th stage on the base substrate 101, where i, j and n are all natural numbers, n is greater than 1, and 0 < i < j ≤ n. The slope angle of the first step side surface 11 refers to an included angle formed between the first step side surface 11 and a plane where the base substrate is located.

In the display substrate of the embodiment of the present application, lengths of parts of film layers in the light emitting functional layer (for example, the charge generation layer) can be prolonged, resistances of parts of the film layers in the light emitting functional layer can be increased, and a flow of carriers between pixels can be reduced; or parts of the film layers in the light emitting functional layer are cut off to prevent the flow of carriers between the pixels and avoid an occurrence of leakage between the pixels.

In the display substrate of the embodiment of the present application, the slope angle ai of the first step of the i-th stage is larger than the slope angle aj of the first step side surface of the first step of the j-th stage, the first side surface 10 is gradually flattened along the light emitting direction of the light emitting functional layer 302, and lengths of parts of the film layers in the light emitting functional layer are prolonged or parts of the film layers in the light emitting functional layer are cut off through a segment difference formed by a large slope angle ai; by using the first step of the j-th stage to slow down a segment difference on the first side surface, avoiding the segment difference being too large, and causing drastic changes in morphology of the second electrode (cathode), the second electrode (cathode) can extend smoothly at the first step 1 of the j-th stage, ensuring uniformity of an electric field distribution between the first electrode (anode) and the second electrode (cathode), and improving the display effect and yield.

In some examples, as shown in FIG. 7, parts of the film layers in the light emitting functional layer 302 may be connected together as a common layer. The light emitting functional layer 302 includes a first film layer portion 3021 located on a side close to the base substrate 101 and a second film layer portion 3022 located on a side away from the base substrate 101, and both of the first film layer portion 3021 and the second film layer portion 3022 may have a continuous structure. The first film layer portion 3021 includes a film layer (e.g., a charge generation layer) with a high carrier mobility, the first film layer portion 3021 covers a first side surface of the pixel definition layer 304, and the first film layer portion 3021 extends along morphology of the n stages of first steps 1. The first film layer portion 3021 forms at least one protrusion part at the n stages of first steps, the at least one protrusion part can extend a length of the first film layer portion 3021 to increase a resistance of the first film layer portion 3021, thereby reducing a flow of carriers between pixels. Or, the first film layer portion 3021 is partitioned by at least one step of the n stages of first steps 1 to avoid the flow of carriers between pixels.

In some embodiments, the first film layer portion may be disconnected at the first step of the i-th stage and the second film layer portion and the second electrode (cathode) may be in a continuous structure so that morphology of the second electrode (cathode) at the first step of the j-th stage is gentle, which will not be repeated here in the embodiment of the present application.

In some examples, a first step side surface of a first step 1 may be planar. Or, a first step side surface of a first step 1 may be non-planar, for example, the first step side surface of the first step may be a curved surface. When the first step side surface is a curved surface, a slope angle of the first step side surface is an included angle formed by a connection line between two end points of the first step side surface and the plane where the base substrate is located.

In some examples, a first step top surface of a first step may be planar. Or, a first step top surface of a first step may be non-planar, for example, the first step top surface of the first step may be a curved surface.

In some examples, a length of the first step side surface 11 of the first step is 10% to 15% of a thickness of the first electrode 301, where the length of the first step side surface 11 is a distance between the two end points of the first step side surface 11.

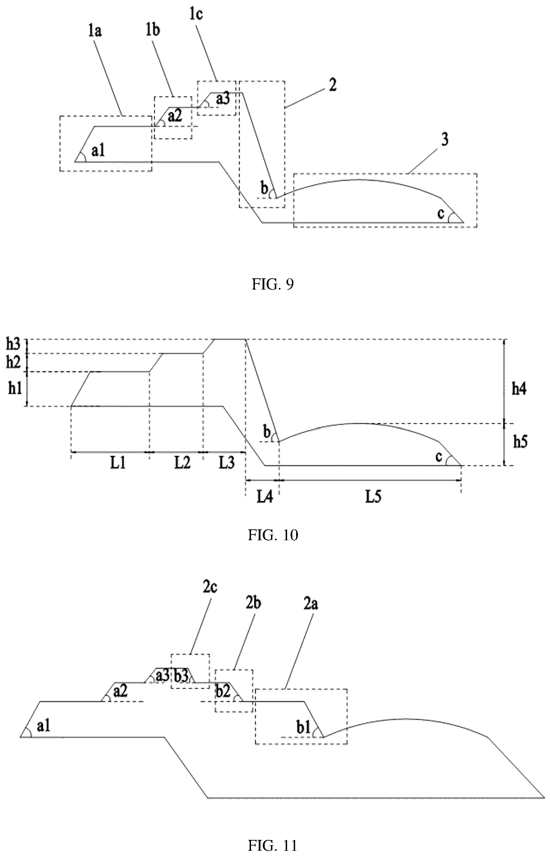

FIG. 9 is a first enlarged view of a pixel definition layer in a display substrate according to an embodiment of the present application. In some examples, as shown in FIG. 9, the first side surface of the pixel definition layer includes a the first step 1a of a first stage, a the first steplb of a second stage and a first step 1c of a third stage that are sequentially arranged along the light emitting direction of the light emitting functional layer. There is no overlapping area between any two an orthographic of the first step 1a of the first stage on the base substrate, an orthographic of the first step 1b of the second stage on the base substrate, and an orthographic of the first step 1c of the third stage on the base substrate. A slope angle a1 of a first step side surface of the first step 1a of the first stage is greater than a slope angle a2 of a first step side surface of the first step 1b of the second stage, and the slope angle a2 of the first step side surface of first step 1b of the second stage is greater than a slope angle a3 of a first step side surface of the first step 1c of the third stage. The slope angle a1 of the first step side surface of the first step 1a of the first stage may be 65 degrees to 75 degrees, the slope angle a2 of the first step side surface of the first step 1b of the second stage may be 50 degrees to 60 degrees, and the slope angle a3 of the first step side surface of the first step 1c of the third stage may be 40 degrees to 45 degrees.

In some examples, the first step 1 of the i-th stage and the first step 1 of the j-th stage may be adjacent, and other first steps 1 may be provided between the first step 1 of the i-th stage and the first step 1 of the j-th stage, for example, n may be 3, j may be 3, i may be 1, and the first step 1 of the second stage may be provided between the first step 1 of the first stage and the first step 1 of the third stage, as shown in FIG. 9.

In some examples, a thickness of the first step 1 of the i-th stage is greater than a thickness of the first step 1 of the j-th stage, where a thickness of a first step 1 is a length of the first step 1 in a direction perpendicular to the plane where the base substrate is located. When the first step top surface of the first step 1 is a curved surface, the thickness of the first step 1 is a minimum length of the first step 1 in the direction perpendicular to the plane where the base substrate is located.

In the display substrate of the embodiment of the present application, through the thickness of the first step 1 of the i-th stage is greater than the thickness of the first step 1 of the j-th stage, the first side surface 10 is gradually flattened along the light emitting direction of the light emitting functional layer 302, lengths of parts of the film layers in the light emitting functional layer are prolonged or cut off by the first step 1 of the i-th stage, the first step 1 of the j-th stage can slow down a segment difference, and the second electrode (cathode) can extend smoothly at the first step 1 of the j-th stage.

FIG. 10 is a second enlarged view of a pixel definition layer in a display substrate according to an embodiment of the present application. In some examples, as shown in FIG. 10, a thickness h1 of the first step 1a of the first stage is greater than a thickness h2 of the first step 1b of the second stage and the thickness h2 of the first step 1b of the second stage is greater than a thickness h3 of the first step 1c of the third stage. For example, the thickness h1 of the first step 1a of the first stage may be 55nm to 80nm, the thickness h2 of the first step 1b of the second stage may be 30nm to 50nm, and the thickness h3 of the first step 1c of the third stage may be 15nm to 25nm.

The above structures of the first side surface of the display substrate of the embodiment of the present disclosure is conducive to an etching process of the first side surface of the pixel definition layer 304, so that parts of the film layers in the light emitting functional layer can be prolonged or cut off at the first step 1 of the i-th stage, and the second electrode (cathode) can extend smoothly at the first step 1 of the j-th stage.

In some examples, a length of the first step 1 of the i-th stage is greater than a length of the first step 1 of the j-th stage, where a length of the first step 1 is a distance between two end points of the first step 1 in a direction parallel to the base substrate.

In some examples, as shown in FIG. 10, a length L1 of the first step 1a of the first stage is greater than a length L2 of the first step 1b of the second stage and the length L2 of the first step 1b of the second stage is greater than a length L3 of the first step 1c of the third stage. For example, the length L1 of the first step 1a of the first stage is 40nm to 80nm, the length L2 of the first step 1b of the second stage is 90nm to 110nm, and the length L3 of the first step 1c of the third stage is 120nm to 200 nm.

The above structures of the first side surface of the display substrate of the embodiment of the present disclosure is conducive to the etching process of the first side surface of the pixel definition layer 304, so that parts of the film layers in the light emitting functional layer can be prolonged or cut off at the first step 1 of the i-th stage, and the second electrode (cathode) can extend smoothly at the first step 1 of the j-th stage.

In some examples, as shown in FIG. 7, the pixel definition layer 304 further includes a second side surface 20 located on a side away from the first electrode 301, the second side surface 20 is located on a side away from the pixel opening. An included angle formed between the second side surface 20 and a surface of the base substrate 101 may be an obtuse angle, thereby ensuring continuity of the second electrode (cathode) and preventing the second electrode (cathode) from being cut off at the second side surface 20.

In some examples, as shown in FIG. 8 and FIG. 9, the second side surface 20 may include a second step 2, and the second step 2 includes a second step side surface 21, an extension direction of the second step side surface 21 is different from each of the extension direction of the first step side surface 11 and the extension direction of the first step top surface 12. A slope angle b of the second step side surface 21 is greater than the slope angle ai of the first step side surface of the first step of the i-th stage, where the slope angle b of the second step side surface 21 may be 80 degrees to 90 degrees.

In some examples, the second step side surface of the second step 2 may be planar. Or, the second step side surface of the second step 2 may be non-planar, for example, the second step side surface of the second step 2 may be a curved surface. When the second step side surface of the second step 2 is a curved surface, a slope angle of the second step side surface of the second step 2 is an included angle formed by a connection line between two end points of the second step side surface and the plane where the base substrate is located.

In the display substrate of the embodiment of the present disclosure, with a great slope angle b of the second step side surface 21, parts of the film layers in the light emitting functional layer 303 can be sufficiently prolonged or parts of the film layers in the light emitting functional layer 303 can be cut off, such as a hole injection layer and a charge generation layer and the second electrode on the second step 2 of the second side surface 20 has an insignificant impact on a display effect, and a change in morphology of the second electrode on the second step 2 has an insignificant impact on the display effect.

In some examples, as shown in FIG. 10, a thickness h4 of the second step 2 is greater than a sum of the thickness h1 of the first step 1a of the first stage, the thickness h2 of the first step 1b of the second stage, and the thickness h3 of the first step 1c of the third stage, i.e., h4 is greater than h1+h2+h3.

In some examples, as shown in FIG. 8, a distance between an end point of the second step 2 close to the base substrate 101 and a surface of the base substrate 101 is less than a distance between the first electrode 301 and the surface of the base substrate 101, and a distance between an end point of the second step 2 away from the base substrate 101 and the surface of the base substrate 101 is greater than a distance between the first electrode 301 and the surface of the base substrate 101, i.e., the end point of the second step 2 close to the base substrate 101 is lower than the surface of the first electrode 301 and the end point of the second step 2 away from the base substrate 101 is higher than the surface of the first electrode 301.

In some examples, as shown in FIG. 8, an orthographic projection of at least a portion of the second step side surface 21 of the second step 2 on the base substrate is not overlapped with an orthographic projection of the first electrode 301 on the base substrate 101, and a distance L6 between an edge of the second step side surface 21 away from the first side surface and an edge of the first electrode away from the first side surface is greater than 150Å, ensuring that the second step 2 can completely cover the first electrode 301 and preventing defects such as corrosion of the first electrode 301 due to not being covered by the second step 2.

FIG. 11 is a third enlarged view of a pixel definition layer in a display substrate according to an embodiment of the present application. In some examples, as shown in FIG. 11, the second side surface 20 may include m stages of second steps that are sequentially arranged along the light emitting direction of the light emitting functional layer 302, a slope angle of a second step side surface of a second step of a z-th stage is greater than a slope angle of a second step side surface of a second step of a k-th stage, the second step of the z-th stage is located on a side of the k-th stage of the second step close to the base substrate, and an orthographic projection of the the second step of the z-th stage on the base substrate 101 is not overlapped with an orthographic projection of the second step of the k-th stage on the base substrate 101, where z, k and m are all natural numbers, m is greater than 1, and 0 < z < k ≤ m.

In some examples, as shown in FIG. 11, the second side surface of the pixel definition layer 304 includes a second step 2a of the first stage, a second step 2b of the second stage, and a second step 2c of the third stage that are sequentially arranged along the light emitting direction of the light emitting functional layer. There is no overlapping area between any two an orthographic projection of the second step 2a of the first stage on the base substrate, an orthographic projection of the second step 2b of the second stage on the base substrate, and an orthographic projection of the second step 2c of the third stage on the base substrate. A slope angle b1 of a second step side surface of the second step 2a of the first stage is greater than a slope angle b2 of a second step side surface of the second step 2b of the second stage, and the slope angle b2 of the second step side surface of the second step2b of the second stage is greater than a slope angle b3 of a second step side surface of the second step 2c of the third stage.

In the display substrate of the embodiment of the present application, the slope angle of the second step of the z-th stage is greater than the slope angle of the second step of the k-th stage, so that the second side surface 20 is gradually flattened along the light emitting direction of the light emitting functional layer 302. By using the second step of the k-th stage to slow down a segment difference of the second side surface, the segment difference is avoided from being too large, which causes drastic changes in the morphology of the second electrode (cathode), so that the second electrode (cathode) can extend smoothly at the second step 2 of the k-th stage.

In some examples, as shown in FIG. 11, a quantity of stages of the m stages of the second steps on the second side surface can be the same as a quantity of the n stages of the first steps on the first side surface, i.e., m equals n, and the m stages of the second steps on the second side surface may be disposed in mirror symmetry with the n stages of the first steps on the first side surface with respect to an axis which is a center line of the pixel definition layer which is perpendicular to a direction of the base substrate as.

In some examples, the quantity of the m stages of the second steps on the second side surface can be different from the quantity of the n stages of the first steps on the first side surface, i.e., m is not equal to n, for example, m is greater than n, or m is less than n.

In some examples, as shown in FIG. 8, the second side surface 20 may include a third step 3, and the third step 2 is located between the second step 2 and the base substrate. The third step 3 includes a third step side surface 31 and a third step top surface 32, and an extension direction of the third step side surface 31 is different from an extension direction of the third step top surface 32. An obtuse angle is formed between the extension direction of the third step side surface 31 and the surface of the base substrate 101, and the extension direction of the third step side surface 32 is substantially parallel to the plane where the base substrate 101 is located. A slope angle c of the third step side surface 31 is less than the slope angle b of the second step side surface of the second step.

In the display substrate of the embodiment of the present disclosure, the slope angle c of the third step side surface 31 can reduce a segment difference of the second side surface 20 and slow down a change in morphology of the second electrode on the third step 3.

In some examples, the third step side surface of the third step 3 may be planar, or the third step side surface of the third step 3 may be non-planar, for example, the third step side surface of the third step 3 may be a curved surface. When the third step side surface of the third step 3 is a curved surface, the slope angle of the third step side surface of the third step 3 is an included angle formed by a connection line of two end points of the third step side surface and the plane where the base substrate is located.

In some examples, the third step top surface of the third step 3 may be planar, or the third step top surface of the third step 3 may be non-planar, for example, the third step top surface of the third step 3 may be a curved surface.

In some examples, as shown in FIG. 8, a distance between the third step top surface 32 of the third step 3 and the surface of the base substrate 101 is less than a distance between the first electrode 301 and the surface of the base substrate 101, and a thickness of the third step 3 is less than a thickness of the first electrode 301.

In some examples, as shown in FIG. 10, a thickness h5 of the third step 3 is less than a thickness h4 of the second step 2. When the third step top surface 32 of the third step 3 is a curved surface, the thickness h5 of the third step 3 is a thickness measured at the highest point of the third step top surface 32.

The above structures of the second side surface of the display substrate of the embodiment of the present disclosure is conducive to an etching process of the second side surface of the pixel definition layer 304, so that the second electrode (cathode) can extend smoothly at the third step 3.

In some examples, a length of the third step 3 is greater than a sum of a total length of the n stages of first steps and the length of the second step. For example, as shown in FIG. 10, a length L5 of the third step 3 is greater than a sum of the length L1 of the first step 1a of the first stage, the length L2 of the first step 1b of the second stage, the length L3 of the first step 1c of the third stage, and the length L4 of the second step 2. Among them, the length of the third step 3 is a distance between the two end points of the third step 3 in a direction parallel to the base substrate.

The above structures of the third step 3 of the display substrate of the embodiment of the present disclosure is conducive to an etching process of the third step 3 of the pixel definition layer 304, so that the second electrode (cathode) can extend smoothly at the third step 3.

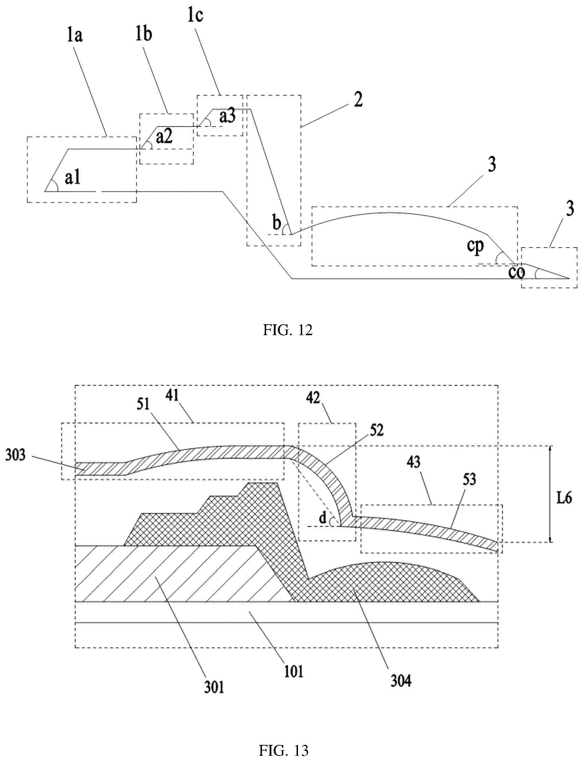

FIG. 12 is a fourth enlarged view of a pixel definition layer in a display substrate according to an embodiment of the present application. In some examples, as shown in FIG. 12, in some examples, the second side surface 20 may include r stages of third steps 3 that are sequentially arranged along the light emitting direction of the light emitting functional layer 302, a slope angle co of a third step side surface of a third step 3 of a o-th stage is less than a slope angle cp of a third step side surface of a third step 3 of a p-th stage, the third step 3 of the o-th stage is located on a side of the third step 3 of the p-th stage close to the base substrate, and an orthographic projection of the third step 3 of the o-th stage on the base substrate 101 is not overlapped with an orthographic projection of the third step 3 of the p-th stage on the base substrate 101, where, r, o and p are all natural numbers, r is greater than 1, and 0 < o < p ≤ r.

In the display substrate of the embodiment of the present application, the slope angle co of the third step side surface of the third step 3 of the o-th stage is less than the slope angle cp of the third step side surface of the third step 3 of the p-th stage, so as to avoid the segment difference of the second side surface from being too large, which causes drastic changes in the morphology of the second electrode (cathode), so that the second electrode (cathode) can extend smoothly.

In some examples, a quantity of the r stages of the third steps 3 on the second side surface may be the same as a quantity of the n stages of the first steps 1 on the first side surface, i.e., r equals n.

In some examples, the quantity of the r stages of the third steps 3 on the second side surface may be different from the quantity of the stages of the first step 1 of n stages on the first side surface, i.e., r is not equal to n, for example, r is greater than n, or r is less than n.

FIG. 13 is an enlarged view of a second electrode in a display substrate according to an embodiment of the present application. In some examples, as shown in FIG. 13, the second electrode 303 includes a first portion 41 covering the first side surface of the pixel definition layer 304, a second portion 42 covering the second step of the second side surface of the pixel definition layer 304, and a third portion 43 covering the third step of the second side surface of the pixel definition layer 304. The first portion 41, the second portion 42, and the third portion 43 are connected sequentially, a surface of the first portion 41 includes at least one first curved surface 51, and an orthographic projection of the at least one first curved surface 51 on the base substrate may be overlapped with an orthographic projection of the first step of the first side surface on the base substrate. A surface of the second portion 42 includes at least one second curved surface 52, and an orthographic projection of the at least one second curved surface 52 on the base substrate may be overlapped with an orthographic projection of the second step of the second side surface on the base substrate. A surface of the third portion 43 includes at least one third curved surface 53, and an orthographic projection of the at least one third curved surface 53 on the base substrate may be overlapped with an orthographic projection of the third step of the second side surface on the base substrate. Among them, a curvature change of the at least one first curved surface 51 of the first portion 41 is less than a curvature change of the at least one second curved surface 52 of the second portion 42, and a curvature change of the at least one third curved surface 53 of the third portion 43 is less than the curvature change of the at least one second curved surface 52 of the second portion 42.

In the display substrate of the embodiment of the present disclosure, the curvature change of the at least one first curved surface 51 of the first portion 41 is less than the curvature change of the at least one second curved surface 52 of the second portion 42, so that it is ensured that the first portion 41 will not be broken.

In some examples, as shown in FIG. 13, a slope angle d of the second portion 42 of the second electrode 303 may be 35 degrees to 45 degrees to ensure that the second portion 42 of the second electrode 303 will not be broken due to drastic changes in morphology. The slope angle of the second portion 42 is an included angle formed between a connection line of two end points of the second portion 42 and the plane where the base substrate is located.

In some examples, as shown in FIG. 13, a distance L6 between a highest point of a surface of the second electrode 303 and a lowest point of the surface of the second electrode 303 is less than 800Å, and prevent the second electrode 303 from being broken due to excessive segment difference.

In some examples, the second electrode 303 may be in a double-layer structure, for example, the second electrode 303 may include a metallic silver layer or a magnesium-silver alloy layer on a side close to the first electrode, and an indium tin oxide layer or an indium zinc oxide layer on a side away from the first electrode. Optionally, the second electrode 303 may also be in a single-layer structure, for example, the second electrode 303 may be a single-layer metallic silver layer or a single-layer magnesium-silver alloy layer.

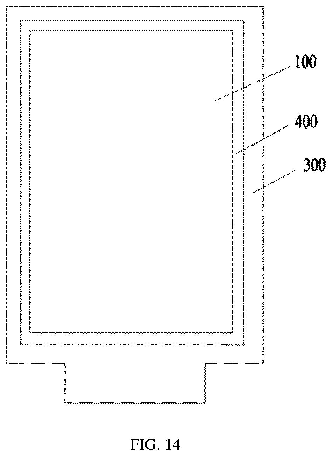

FIG. 14 is a second schematic diagram of a structure of a display substrate according to an embodiment of the present application. In some examples, as shown in FIG. 14, a display substrate of an embodiment of the present application further includes a virtual display area 400, and at least a portion of the virtual display area 400 is located between the display area 100 and the bezel area 300. The virtual display area 400 may include a base substrate, a virtual drive circuit layer disposed on the base substrate, and a virtual light emitting structure layer disposed on a side of the virtual drive circuit layer away from the base substrate. The virtual display area 400 does not display a dynamic picture or a static image.

In some examples, at least a portion of the pixel definition layer of the display area 100 is located at an edge of the display area 100 close to the virtual display area 400, and the pixel definition layer includes a third side surface on a side close to the display area 100. The third side surface includes q stages of fourth steps that are sequentially arranged along a light emitting direction of the display area 100. Each fourth step includes a fourth step side surface and a fourth step top surface, an extension direction of the fourth step side surface is different from an extension direction of the fourth step top surface. A slope angle of a fourth step side surface of a fourth step of an s-th stage is greater than a slope angle of a fourth step side surface of a fourth step of a u-th stage, the fourth step of the s-th stage is located on a side of the fourth step of the u-th stage close to the base substrate, and an orthographic projection of the fourth step of the s-th stage on the base substrate is not overlapped with an orthographic projection of the fourth step of the u-th stage on the base substrate, where s, u and q are all natural numbers, q is greater than 1, and 0 < s < u ≤ q.

In some examples, the q stages of fourth steps on the third side surface of the pixel definition layer may have a same structure as the n stages of first steps on the first side surface of the pixel definition layer, which will not be repeated here in the embodiments of the present application.

The above structures of the third side surface of the display substrate of the embodiment of the present disclosure make the third side surface be gradually flattened along the light emitting direction of the display area 100, lengths of parts of the film layers in the light emitting functional layer are prolonged or cut off by a segment difference formed by the fourth step of the s-th stage. By using the fourth step of the u-th stage to slow down a segment difference on the third side surface, avoiding the segment difference from being too large which causes drastic changes in morphology of the second electrode (cathode).

In some examples, the pixel definition layer further includes a fourth side surface on a side close to the virtual display area 400, and the fourth side surface may include a fifth step. The fifth step includes a fifth step side surface, and a slope angle of the fifth step side surface is greater than the slope angle of the fourth step side surface of the fourth step of the s-th stage.

In some examples, the fifth step of the fourth side surface of the pixel definition layer may have a same structure as the second step of the second side surface of the pixel definition layer, which will not be repeated here in the embodiments of the present application.

In some examples, the fourth side surface may include a sixth step, and the sixth step is located between the fifth step and the base substrate. The sixth step includes a sixth step side surface and a sixth step side surface, and a slope angle of the sixth step side surface is less than the slope angle of the fifth step side surface of the fifth step.

In some examples, the sixth step of the fourth side surface of the pixel definition layer may have a same structure as the third step of the second side surface of the pixel definition layer, which will not be repeated here in the embodiments of the present application.

In the display substrate of the embodiment of the present disclosure, a segment difference of the fourth side surface can be reduced by the sixth step to slow down a change in morphology of the second electrode on the sixth step.

The present disclosure further provides a display apparatus, including a display substrate according to the aforementioned embodiments. The display apparatus may be any product or component with a display function, such as a mobile phone, a tablet computer, a television, a display, a laptop computer, a digital photo frame, or a navigator.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict.

Those of ordinary skills in the art should understand that modifications or equivalent replacements may be made to the technical solutions of the present disclosure without departing from the spirit and scope of the technical solutions of the present disclosure, and shall all fall within the scope of the claims of the present disclosure.

## Claims

1. A display substrate, comprising:
a base substrate;
a light emitting element disposed on the base substrate, the light emitting element comprises a first electrode, a light emitting functional layer, and a second electrode that are sequentially stacked along a direction away from the base substrate;
a pixel definition layer disposed on the base substrate, the pixel definition layer is provided with a pixel opening, the pixel opening exposes at least a portion of a surface of the first electrode, and at least a portion of the second electrode covers the pixel opening;
wherein the pixel definition layer comprises a first side surface on a side close to the first electrode, the first side surface comprises n stages of first steps that are sequentially arranged along a light emitting direction of the light emitting functional layer, each first step comprises a first step side surface, a slope angle of a first step side surface of a first step of an i-th stage is greater than a slope angle of a first step side surface of a first step of a j-th stage, and the first step of the i-th stage is located on a side of the first step of the j-th stage close to the base substrate;
where i, j and n are all natural numbers, n is greater than 1, and 0 < i < j ≤ n.

2. The display substrate according to claim 1, wherein the first side surface comprises 3 stages of first steps that are sequentially arranged along the light emitting direction of the light emitting functional layer, a slope angle of a first step side surface of a first step of a first stage is greater than a slope angle of a first step side surface of a first step of a second stage, and the slope angle of the first step side surface of the first step of the second stage is greater than a slope angle of a first step side surface of a first step of a third stage.

3. The display substrate according to claim 2, wherein the slope angle of the first step side surface of the first step of the first stage is 65 degrees to 75 degrees; the slope angle of the first side surface of the first step of the second stage is 50 degrees to 60 degrees; and the slope angle of the first step side surface of the first step of the third stage is 40 degrees to 45 degrees.

4. The display substrate according to claim 1, wherein a thickness of the first step of the i-th stage is greater than a thickness of the first step of the j-th stage.

5. The display substrate according to claim 1, wherein a length of the first step of the i-th stage is greater than a length of the first step of the j-th stage.

6. The display substrate according to any one of claims 1 to 5, wherein the pixel definition layer further comprises a second side surface on a side away from the first electrode, the second side surface comprises one second step, the second step comprises a second step side surface, and a slope angle of the second step side surface of the second step is greater than the slope angle of the first step side surface of the first step of the i-th stage.

7. The display substrate according to claim 6, wherein the slope angle of the second step side surface of the second step is 80 degrees to 90 degrees.

8. The display substrate according to any one of claims 1 to 5, wherein the pixel definition layer further comprises a second side surface on a side away from the first electrode, the second side surface comprises m stages of second steps that are sequentially arranged along the light emitting direction of the light emitting functional layer, each second step comprises a second step side surface, a slope angle of a second step side surface of a second step of a z-th stage is greater than a slope angle of a second step side surface of a second step of a k-th stage, and the second step of the z-th stage is located on a side of the second step of the k-th stage close to the base substrate.

9. The display substrate according to claim 8, wherein the m stages of the second steps are disposed in mirror symmetry with the n stages of the first steps with respect to an axis which is a center line of the pixel definition layer perpendicular to a direction of the base substrate.

10. The display substrate according to claim 8, wherein a quantity of the m stages of the second steps is less than a quantity of the n stages of the first steps.

11. The display substrate according to claim 6, wherein an orthographic projection of at least a portion of the second step side surface of the second step on the base substrate is not overlapped with an orthographic projection of the first electrode on the base substrate; and a distance between an edge of the second step side surface away from the first side surface and an edge of the first electrode away from the first side surface is greater than 150Å.

12. The display substrate according to claim 6, wherein the second electrode comprises a first portion covering the first side surface and a second portion covering the second step, the first portion is connected with the second portion, a surface of the first portion comprises at least one first curved surface, a surface of the second portion comprises at least one second curved surface, a curvature change of the at least one first curved surface is less than a curvature change of the at least one second curved surface.

13. The display substrate according to claim 12, wherein a slope angle of the second portion is 35 degrees to 45 degrees.

14. The display substrate according to claim 6, wherein the second side surface further comprises one third step, the third step is located between the second step and the base substrate, the third step comprises a third step side surface, and a slope angle of the third step side surface of the third step is less than the slope angle of the second step side surface of the second step.

15. The display substrate according to claim 14, wherein a length of the third step is greater than a sum of a total length of the n stages of the first steps and a length of the second step.

16. The display substrate according to claim 6, wherein the second side surface comprises r stages of third steps that are sequentially arranged along the light emitting direction of the light emitting functional layer, the r stages of third steps are located between the second step and the base substrate, each third step comprises a third step side surface, a slope angle of a third step side surface of a third step of a o-th stage is less than a slope angle of a third step side surface of a third step of a p-th stage, and the third step of the o-th stage is located on a side of the third step of the p-th stage close to the base substrate.

17. The display substrate according to any one of claims 1 to 16, wherein a surface of the second electrode is uneven, and a distance between a highest point of the surface of the second electrode and a lowest point of the surface of the second electrode is less than 800Å.

18. The display substrate according to any one of claims 1 to 16, wherein a length of the first step side surface of the first step is 10% to 15% of a thickness of the first electrode.

19. The display substrate according to any one of claims 1 to 16, wherein the light emitting functional layer comprises a first film layer portion located on a side close to the base substrate and a second film layer portion located on a side away from the base substrate, and the first film layer portion forms at least one protrusion part at the n stages of the first steps.

20. A display apparatus, comprising the display substrate according to any one of claims 1 to 19.
